# EUROPÄISCHE PATENTSCHRIFT

(11) **EP 1 504 649 B1**
(45) Veröffentlichungstag und Bekanntmachung des Hinweises auf die Patenterteilung: **06.12.2006**
(21) Anmeldenummer: 04010396.2
(22) Anmeldetag: 03.05.2004
(51) Int. Cl.: A01D 41/127, B60K 25/00

(54) **Verfahren zur Überwachung der Funktion einer Arbeitsmaschine**
Method of controlling the functions of a working machine
Procédé de surveillance de la fonction d'une machine de travail

(30) Priorität: 02.08.2003 DE 10335558
(43) Veröffentlichungstag der Anmeldung: 09.02.2005
(73) Patentinhaber: Dr.Ing. h.c.F. Porsche Aktiengesellschaft, 70435 Stuttgart (DE)
(72) Erfinder: Kappich, Joachim, 75378 Bad Liebenzell (DE); Stankewitz, Britta, 75181 Pforzheim (DE)

(56) Entgegenhaltungen:
- EP-A- 1 195 612
- EP-A- 1 221 279
- DE-A- 19 740 346
- DE-C- 10 116 544
- DE-C- 10 122 517

## Beschreibung

Die Erfindung betrifft Arbeitsmaschinen, wie sie beispielsweise aus der DE 197 40 346 A1 bekannt sind. In dieser DE 197 40 346 A1 ist ausgeführt, dass die bekannten selbstfahrenden Arbeitsmaschinen wie beispielsweise Mähdrescher, Feldhäcksler, Traktoren oder auch Baumaschinen neben einem Antriebsaggregat in der Regel noch aus mehreren Nebenantrieben mit einer größeren Anzahl von Arbeitsaggregaten bestehen.
So weist ein selbstfahrender Mähdrescher neben dem Fahrantrieb in Form eines mechanischen Antriebes oder eines den Antriebsmotor nachgeordneten Hydrostaten, von dem aus die Antriebsleitung hydrostatisch auf die Antriebsräder übertragen wird, eine Vielzahl von Arbeitsaggregaten wie Schneidwerk, Dresch- und Abscheideorgane, Strohhäcksler, Gebläse usw. auf, die als Nebenabtriebe von der Motorwelle des Antriebsmotors zusätzlich direkt oder indirekt angetrieben werden. Damit ein sicherer Einsatz eine Arbeitsmaschine an die unterschiedlichen Ansatzsituationen, wie beispielsweise bei Fahrten in unterschiedlich dichtem Erntegutbestand, bei Ernteeinsätzen auf hügeligem Gelände, bei unterschiedlichen Bodenverhältnissen und Straßenfahrten gewährleistet ist, ist es üblich, die Funktion der Einzelaggregate zu überwachen. Da es sich im Wesentlichen um drehende Bauteile handelt, ist bekanntermaßen wenigstens einen Sensor zur Erfassung von Schwingungen vorzusehen und den zu überwachenden Elementen einen Drehzahlsensor zuzuordnen. Der Drehzahlsensor erfasst die Drehfrequenz der zu überwachenden Elemente, so dass in einer Auswerteeinrichtung die im gesamten Antriebssystem erfassten Drehzahlbewegungsfrequenzen den Signalen des Bewegungs- und/oder Schwingungssensors zugeordnet, so dass beide Daten miteinander korreliert werden. Der Vergleich mit abgelegten Werten für die Amplitude und die Frequenz des Signals erlaubt eine Zuordnung, ob ein Fehler im System vorliegt.

Ausgehend von diesen bekannten Zusammenhängen liegt dem erfindungsgemäßen Verfahren die Aufgabe zugrunde, eine verbesserte Fehlererkennung zu finden, die sicherstellt, dass auch bei unterschiedlichsten Nutzungsbedingungen der Arbeitsmaschine eine sichere Erkennung von Abweichungen gewährleistet ist.

Das erfindungsgemäße Verfahren mit den Merkmalen des Hauptanspruchs hat gegenüber dem Bekannten den Vorteil, dass durch die Nutzung drehzahlabhängiger Filter eine eindeutigere Aussage, ob ein Fehler vorliegt, möglich ist. Die Frequenz der einzelnen Bauteile ändert sich mit der Drehzahl, so dass eine Filterung mit festen Frequenzen nicht sinnvoll ist und Fehler unter Umständen nicht sicher erkannt werden können. Bei rotierenden und oszillierenden Elementen besteht ein direkter Zusammenhang zwischen der Drehzahl und einem Vielfachen der Drehzahl des Elementes und den von ihn angeregten Frequenzen. Es ist daher davon auszugehen, dass Änderungen in der Funktion des Elementes sich in einer Änderung der Amplitude dieser Frequenzen auswirken.

Das erfindungsgemäße Verfahren ist in der Zeichnung dargestellt und in der nachfolgenden Beschreibung näher erläutert.

Es zeigen
Figur 1 eine selbstfahrende Arbeitsmaschine als Prinzipbild und
Figur 2 den prinzipiellen Ablaufplan zur Durchführung der Funktionsüberwachung einer Arbeitsmaschine mit einem drehzahlabhängigen Filter.

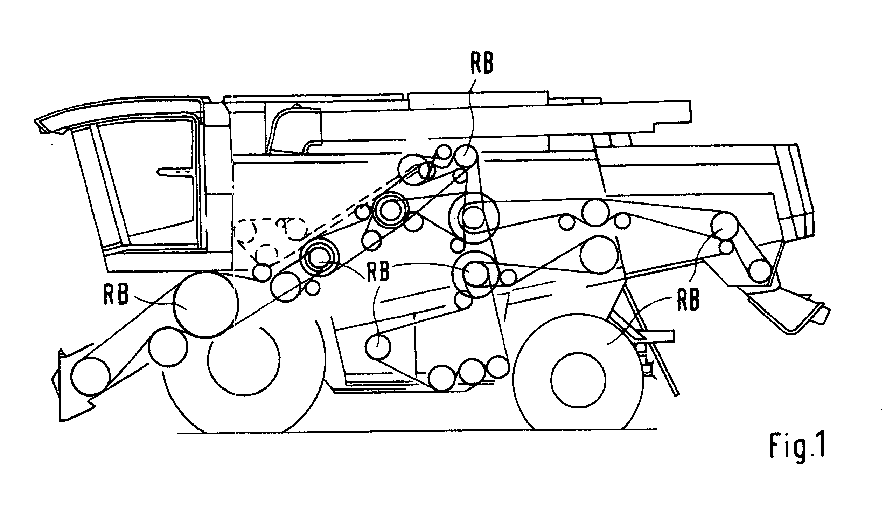

Figur 1 ist lediglich zur Verdeutlichung der Vielzahl an rotierenden Bauteilen, die in er Figur 1 mit dem Bezugzeichen RB gekennzeichnet sind, dargestellt und zeigt die Komplexität einer selbstfahrenden Arbeitsmaschine.

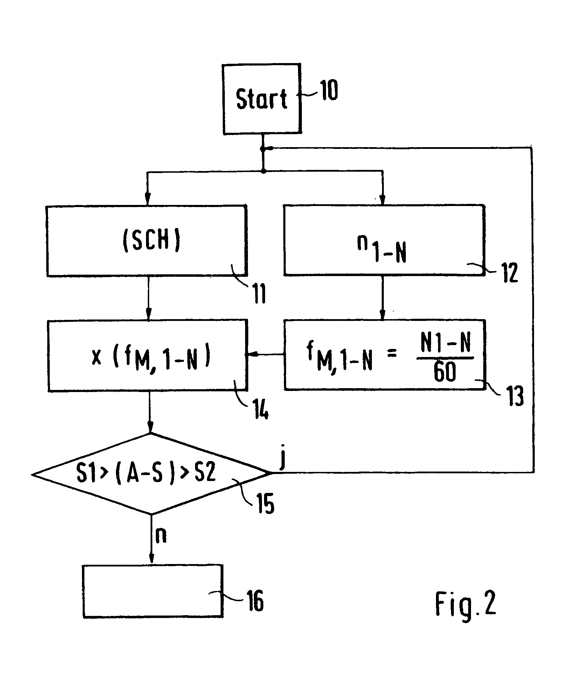

Das erfindungsgemäße Verfahren selbst soll nun unter Zuhilfenahme der Figur 2 erläutert werden. Nach dem Start 10 des Verfahrens zur Überwachung der Funktion der Arbeitsmaschine werden in einem Arbeitsschritt 11 die Signale zumindest eines, hier nicht dargestellten Schwingungssensors erfasst und als Schwingsignal x(SCH) für die weitere Bearbeitung abgelegt. In einem parallelen Arbeitsschritt 12 werden die Signale von ebenfalls in den Figuren nicht dargestellten Drehzahlsensoren erfasst und die ermittelten Drehzahlwerte n in einem anschließend an einen Arbeitsschritt 13 geführt. Die Anzahl 1 bis x der Drehzahlsensoren, welche die jeweiligen Drehzahlwerte n_{1-N} liefern und der jeweilige Anbauort kann beispielsweise in der Applikation ermittelt werden. Des weiteren können die Drehzahlen einzelner Bauteile direkt oder über entsprechende Übersetzungsverhältnisse aus dem CAN ermittelt werden.
Im Arbeitsschritt 13 wird aufgrund der ermittelten Drehzahl n die Mittenfrequenz f_{M,1-N} nachgordneter Ordnungsfilter bestimmt, so dass im Arbeitsschritt 14 die erfassten Schwingungen x(SCH) mittels eines drehzahlabhängigen Ordnungsfilter gefiltert werden. Die so aufbereiteten Signale der Schwingungssensoren werden im nachfolgenden Arbeitsschritt 15 mit verschiedenen abgelegten Schwellwerten verglichen.

Hierbei erfolgt zunächst der Vergleich mit einem ersten Schwellwert S1, welcher negativ ist. Dieser Vergleich stellt sicher, ob die Amplitude des ordnungsgefilterten Signals wesentlich größer als der Vergleichswert ist.

Des Weiteren wird geprüft, ob die Differenz der Amplitude A des ordnungsgefilterten Signals und einem Vergleichswert S (Sollwert) kleiner als ein zweiter abgespeicherter Schwellwert S2 ist, ist die Amplitude des ordnungsgefilterten Signals abzüglich des Vergleichswertes größer als der zweite Schwellwert S2, so deutet dies auf zu hohe Schwingungen hin.

Ist die Amplitude des ordnungsgefilterten Signals abzüglich des Vergleichswertes kleiner als der erste Schwellwert als S1, so spricht das für einen nicht ordnungsgemäßen Antrieb des Elementes. In beiden Fällen wird in einem nachfolgenden Arbeitsschritt 16 eine Fehlermeldung abgegeben.

Konnte kein Überschreiten des Schwellwertes S1 und kein Unterschreiten des Schwellwertes S2 festgestellt werden, so erkennt das System, dass die Arbeitsmaschine ordnungsgemäß arbeitet und springt zurück an den Anfang des Verfahrens, wobei im Arbeitsschritt 10 erneut die Überwachung beginnt.

## Patentansprüche

1. Verfahren zur Funktionsüberwachung von Arbeitsmaschinen, wobei zumindest ein Sensor zur Erfassung der Schwingungen und eine vorgebbare Anzahl (1 bis x) Sensoren zur Erfassung der Drehzahl (n) der einzelnen Aggregate einer Arbeitsmaschine vorgesehen sind, wobei mittels der erfassten Drehzahl die Mittenfrequenz eines Ordnungsfilters bestimmt wird und die Signale der Schwingungssensoren über ein drehzahlabhängiges Ordnungsfilter ausgewertet werden.

2. Verfahren nach Anspruch 1, **dadurch gekennzeichnet, dass** eine Fehlermeldung ausgegeben wird, wenn das gefilterte Signal der Schwingungssensoren außerhalb einer vorgebbaren Bandbreite liegt.

3. Verfahren nach Anspruch 2, **dadurch gekennzeichnet, dass** die Amplitude des gefilterten Schwingungssignals um einen Sollwert verkleinert wird.

## Claims

1. A method of monitoring the functions of working machines, wherein at least one sensor for detecting the vibrations and a predeterminable number (1 to x) of sensors for detecting the rotational speed (n) of the individual assemblies of a working machine are provided, wherein the centre frequency of an order filter is determined by means of the detected rotational speed, and the signals of the vibration sensors are evaluated by a rotational speed-dependent order filter.

2. A method according to claim 1, **characterised in that** an error message is output if the filtered signal of the vibration sensors lies outside a predeterminable bandwidth.

3. A method according to claim 2, **characterised in that** the amplitude of the filtered vibration signal is reduced by a reference value.

## Revendications

1. Procédé de surveillance du fonctionnement d'engins de travaux, dans lequel sont prévus au moins un capteur destiné à enregistrer des oscillations et un nombre (1 à x) prédéfinissable de capteurs destinés à enregistrer la vitesse de rotation (n) des différents organes d'un engin machine de travaux, la fréquence moyenne d'un filtre d'ordre étant déterminée au moyen de la vitesse de rotation enregistrée et les signaux des capteurs d'oscillations étant analysés par l'intermédiaire d'un filtre d'ordre dépendant de la vitesse de rotation.

2. Procédé selon la revendication 1, **caractérisé en ce qu'**un message d'erreur est délivré lorsque le signal filtré des capteurs d'oscillations se situe en dehors d'une largeur de bande prédéfinissable.

3. Procédé selon la revendication 2, **caractérisé en ce que** l'amplitude du signal d'oscillation est diminuée d'une valeur de consigne.
